(19) Europäisches Patentamt
European Patent Office
Office européen des brevets

(11) **EP 4 632 419 A2**

(12) **EUROPEAN PATENT APPLICATION**

(43) Date of publication:
**15.10.2025 Bulletin 2025/42**

(21) Application number: **25170181.9**

(22) Date of filing: **11.04.2025**

(51) International Patent Classification (IPC):
*G01R 33/56* (2006.01)  *G01R 33/561* (2006.01)
*G01R 33/565* (2006.01)  *G06N 3/045* (2023.01)

(52) Cooperative Patent Classification (CPC):
**G01R 33/5608; G01R 33/561; G01R 33/56545; G06N 3/045**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **12.04.2024 CN 202410444379**

(71) Applicant: **Canon Medical Systems Corporation Tochigi 324-0036 (JP)**

(72) Inventors:
• **WANG, Sha**
  **Beijing (CN)**
• **ZHANG, Lijun**
  **Beijing (CN)**

(74) Representative: **Marks & Clerk LLP**
  **15 Fetter Lane**
  **London EC4A 1BW (GB)**

(54) **MAGNETIC RESONANCE IMAGE RECONSTRUCTION DEVICE AND MAGNETIC RESONANCE IMAGE RECONSTRUCTION METHOD**

(57) A magnetic resonance image reconstruction device (1) according to an embodiment is a magnetic resonance image reconstruction device (1) that reconstructs magnetic resonance image data in which an artifact due to undersampling is removed or reduced based on undersampled k-space data, and includes a reconstruction unit (60) reconstructing the magnetic resonance image data using a reconstruction network (RN) having a correction module. The correction module includes a regularization block (IRN) generating second image data by performing a regularization process on first image data using a first neural network, and a data consistency block (DCB) generating third image data by performing a data consistency process so that k-space data corresponding to the second image data approaches the undersampled k-space data. The correction module further includes at least one of a data consistency adjustment block (DCMB) adjusting the data consistency process and a regularization adjustment block (IRMB) adjusting the regularization process.

FIG.1

1

MAGNETIC RESONANCE IMAGE RECONSTRUCTION DEVICE

INPUT/OUTPUT INTERFACE — 10

DISPLAY INTERFACE — 20

COMMUNICATION INTERFACE — 30

STORAGE UNIT — 40

PREPROCESSING UNIT — 50

RECONSTRUC-TION UNIT — 60

EP 4 632 419 A2

**Description**

FIELD

Embodiments described herein relate generally to a magnetic resonance image reconstruction device and a magnetic resonance image reconstruction method.

BACKGROUND

A magnetic resonance imaging apparatus is a non-invasive medical imaging apparatus that uses a magnetic resonance phenomenon in which hydrogen nuclei in a static magnetic field resonate with a high-frequency magnetic field of a specific frequency. A magnetic resonance imaging technique has been widely applied in the diagnosis of clinical diseases because of its advantages of high resolution, no wounding, and no radiation, and the ability to examine various substantial organs of the human body. The magnetic resonance imaging apparatus includes a magnetic resonance scanning device that scans a subject and a magnetic resonance image reconstruction device that reconstructs images on the basis of scan data.

The magnetic resonance imaging apparatus in the related art uses raster scans to acquire k-space data in a k-space, and performs imaging by performing an inverse Fourier transform on the k-space data after collection of the k-space data is completed. In addition, the magnetic resonance technique in the related art needs to collect complete k-space data, resulting in long scan time, discomfort for patients, and the easy occurrence of motion artifacts.

A technique is known to accelerate the scan time of the magnetic resonance imaging apparatus by sampling only a part of the k-space data and reconstructing an image with undersampled k-space data. Examples of a magnetic resonance image reconstruction device used for this technique include a magnetic resonance image reconstruction device based on algorithms such as parallel imaging or compressed sensing. Such a technique has a low imaging quality because some k-space information is missed.

With the recent development of machine learning technique, a magnetic resonance image reconstruction device using a deep learning technique has been proposed, and the deep learning technique can be used to correct image spaces or k-space data or used for end-to-end reconstruction neural networks. As a deep learning-based magnetic resonance image reconstruction technique, a technique of reconstructing images from undersampled k-space data by using an end-to-end unrolled learning network has been proposed. This technique has advantageous effects such as high reconstruction accuracy and convenient learning. The learning network is a large neural network including multiple subneural networks connected to each other.

"MoDL: Model Based Deep Learning Architecture for Inverse Problems", Aggarwal HK, Mani MP, Jacob M, IEEE Trans Med Imaging, 2019; 38(2): p394-405" discloses a magnetic resonance image reconstruction device based on an end-to-end unrolled learning network, which reconstructs image data from undersampled k-space data by using a convolutional neural network with residual connections as a prior term. The invention in "MoDL: Model Based Deep Learning Architecture for Inverse Problems" performs the same process on input data each having different resolutions, signal-to-noise ratios, scan targets, and the like.

U.S. Patent Application No. 2018-0349759 discloses a medical image processing device based on a neural network that can handle input data with different signal-to-noise ratios, which outputs a control signal on the basis of attributes related to the signal-to-noise ratio of input data and adjusts parameters of the neural network according to the control signal during inference of the neural network.

SUMMARY OF INVENTION

A magnetic resonance image reconstruction device according to an embodiment reconstructs magnetic resonance image data in which an artifact due to undersampling is removed or reduced, based on undersampled k-space data, the magnetic resonance image reconstruction device comprising

a reconstruction unit configured to reconstruct the magnetic resonance image data by using a reconstruction network including a correction module, wherein
the correction module includes:

a regularization block configured to generate second image data by performing a regularization process on first image data by using a first neural network; and
a data consistency block configured to generate third image data by performing a data consistency process so that k-space data corresponding to the second image data approaches the undersampled k-space data, and

the correction module further includes at least one of a data consistency adjustment block configured to adjust the data consistency process and a regularization adjustment block configured to adjust the regularization process.

The regularization block may be configured to perform the regularization process in an image space by using the first neural network so that the first image data approaches magnetic resonance image data in which an artifact due to undersampling is removed or reduced.

The data consistency adjustment block is configured to generate a data consistency weight by using a second neural network based on the second image data, and
the data consistency block is configured to perform the data consistency process based on the data consistency weight.

The regularization adjustment block may be configured to generate a first tensor by using a third neural network based on the first image data, and
the regularization block may be configured to adjust a calculation in a convolution layer in the first neural network based on the first tensor.

The regularization adjustment block may be configured to generate a second tensor by using a fourth neural network based on the first image data, and
the regularization block may be configured to adjust a calculation in an activation layer in the first neural network based on the second tensor.

The regularization adjustment block may include a first image feature extractor configured to extract an image feature in the first image data and generate the first tensor based on the image feature.

The regularization adjustment block may include a first image feature extractor configured to extract an image feature in the first image data and generate the second tensor based on the image feature.

The data consistency adjustment block may include a second image feature extractor configured to extract an image feature in the second image data and generate the data consistency weight based on the image feature.

The third neural network may be a convolutional neural network.

The reconstruction network may include a plurality of the correction modules, and
the first neural network of each of the correction modules may have different parameters.

An activation function of the activation layer may be a ReLU function.

The regularization block may perform the regularization process in a k-space to generate the second image by using the first neural network so that k-space data corresponding to the first image data approaches fully sampled k-space data.

A magnetic resonance image reconstruction method according to an embodiment is a method for reconstructing magnetic resonance image data in which an artifact due to undersampling is removed or reduced, based on undersampled k-space data, the magnetic resonance image reconstruction method comprising:

performing regularization to generate second image data by performing a regularization process on first image data by using a first neural network;
performing data consistency to generate third image data by performing a data consistency process so that k-space data corresponding to the second image data approaches the undersampled k-space data; and
performing adjustment to adjust at least one of the regularization process and the data consistency process.

BRIEF DESCRIPTION OF THE DRAWINGS

FIG. 1 is a diagram illustrating an example of the configuration of a magnetic resonance image reconstruction device according to a first embodiment;
FIG. 2 is a data flow diagram for explaining a process performed by a preprocessing unit according to the first embodiment;
FIG. 3 is a data flow diagram for explaining a reconstruction process performed by a reconstruction unit according to the first embodiment;
FIG. 4 is a block diagram for explaining the configuration of a correction module according to the first embodiment;
FIG. 5 is a data flow diagram for explaining a process by an image space regularization adjustment block included in the correction module according to the first embodiment;
FIG. 6 is a data flow diagram for explaining a process by an image space regularization block included in the correction module according to the first embodiment;
FIG. 7 is a data flow diagram for explaining a convolutional activation process performed by a convolutional activation unit included in an image space regularization neural network according to the first embodiment;
FIG. 8 is a data flow diagram for explaining a process by a data consistency adjustment block included in the correction module according to the first embodiment;

FIG. 9 is a data flow diagram for explaining a process by the correction module according to the first embodiment;

FIG. 10 is a flowchart illustrating the flow of a magnetic resonance image reconstruction method according to the first embodiment;

FIG. 11 is a diagram comparing complete image data reconstructed by the magnetic resonance image reconstruction device according to the first embodiment with complete image data reconstructed according to the related art;

FIGs. 12A to 12C show a comparison of complete image data reconstructed by the magnetic resonance image reconstruction device according to the first embodiment with complete image data reconstructed according to the related art;

FIG. 13 is a block diagram for explaining the configuration of a correction module according to a second embodiment;

FIG. 14 is a data flow diagram for explaining a process by the correction module according to the second embodiment;

FIG. 15 is a flowchart illustrating the flow of a magnetic resonance image reconstruction method according to the second embodiment;

FIG. 16 is a block diagram for explaining the configuration of a correction module according to a third embodiment;

FIG. 17 is a data flow diagram for explaining a process by the correction module according to the third embodiment; and

FIG. 18 is a flowchart illustrating the flow of a magnetic resonance image reconstruction method according to the third embodiment.

DETAILED DESCRIPTION

A magnetic resonance image reconstruction device according to an embodiment is a magnetic resonance image reconstruction device that reconstructs magnetic resonance image data in which an artifact due to undersampling is removed or reduced on the basis of undersampled k-space data, and has a reconstruction unit that reconstructs the magnetic resonance image data by using a reconstruction network having a correction module. The correction module includes a regularization block configured to generate second image data by performing a regularization process on first image data by using a first neural network, and a data consistency block configured to generate third image data by performing a data consistency process so that k-space data corresponding to the second image data approaches the undersampled k-space data. The correction module further includes at least one of a data consistency adjustment block that adjusts the data consistency process and a regularization adjustment block that adjusts the regularization process.

The magnetic resonance image reconstruction device and a magnetic resonance image reconstruction method of the present invention are described below with reference to the drawings.

First Embodiment

A magnetic resonance image reconstruction device according to the present embodiment performs image reconstruction on image data in an image space on the basis of undersampled k-space data obtained by scanning a subject by a magnetic resonance scanning device. The goal is to reconstruct image data equivalent to fully sampled k-space data (referred to as complete image data below). The k-space data is obtained by the aforementioned magnetic resonance scanning device transmitting pulse signals to a subject in a frequency-encoded and phase-encoded magnetic field and receiving echo signals due to specific nuclear magnetic resonance from a plurality of receiving coils. A complete image is, to put it in another way, magnetic resonance image data in which artifacts due to the undersampling is removed or reduced.

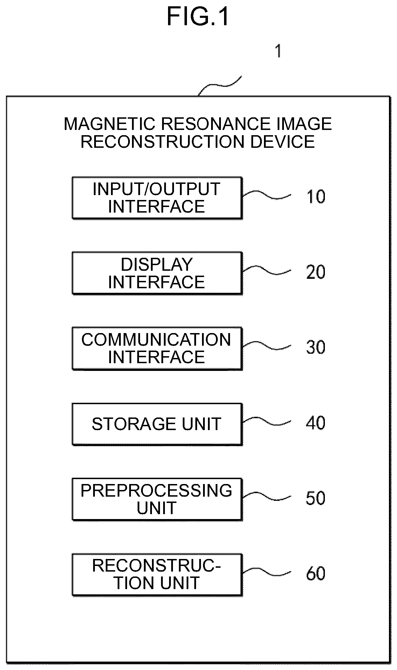

FIG. 1 is a diagram illustrating an example of the configuration of a magnetic resonance image reconstruction device 1 according to a first embodiment. The magnetic resonance image reconstruction device 1 of the first embodiment includes an input/output interface 10, a display interface 20, a communication interface 30, a storage unit 40, a preprocessing unit 50, and a reconstruction unit 60. The input/output interface 10, the display interface 20, the communication interface 30, the storage unit 40, the preprocessing unit 50, and the reconstruction unit 60 are communicably connected to one another.

The input/output interface 10 is an interface for connecting the magnetic resonance image reconstruction device 1 and an input device (not illustrated), receives user input operations from the input device, and transmits signals based on the received input operations to the magnetic resonance image reconstruction device 1. The input/output interface 10 is, for example, a serial bus interface such as USB. Examples of the input device include a mouse, a keyboard, a trackball, a switch, a button, a joystick, a touch screen, a microphone, and the like. The input/output interface 10 may also be connected to a storage device to read and write various types of data to and from the storage device. The storage device is, for example, a hard disk drive (HDD), a solid state drive (SSD), or the like.

The display interface 20 is an interface for connecting the magnetic resonance image reconstruction device 1 to a display device (not illustrated), transmits data to the display device, and causes the display device to display images. The display interface 20 is a video output interface such as a digital visual interface (DVI) or a high-definition multimedia interface (HDMI) (registered trademark). The display device includes a liquid crystal display (LCD), an organic electroluminescence (EL) display, or the like. The display device displays a user interface for receiving input operations from a user, complete image data output by the magnetic resonance image reconstruction device 1, and the like, and the user interface is, for example, a graphical user interface (GUI) or the like.

The communication interface 30 is an interface for connecting the magnetic resonance image reconstruction device 1 to a server (not illustrated), and can transmit and receive various types of data to and from the server. The communication interface 30 is, for example, a network card such as a wireless network card or a wired network card.

The storage unit 40 stores therein user data such as image data and k-space data used for image reconstruction. The storage unit 40 also stores therein parameters used when the magnetic resonance image reconstruction device 1 performs image reconstruction, such as parameters of a neural network. The storage unit 40 also stores therein teacher data for learning each neural network and other learnable parameters used by the magnetic resonance image reconstruction device **1**. The storage unit 40 is implemented by a storage device such as a read-only memory (ROM), a flash memory, a random access memory (RAM), a hard disk drive (HDD), a solid state drive (SSD), or a register. The flash memory, the HDD, the SSD, and the like are nonvolatile storage media. These nonvolatile storage media may be implemented by other storage devices connected via a network, such as a network attached storage (NAS) or an external storage server device. The above network includes, for example, the Internet, a wide area network (WAN), a local area network (LAN), a carrier terminal, a wireless communication network, a wireless base station, and a leased line.

The preprocessing unit 50 performs preprocessing on undersampled k-space data $K_0$ being input data for the magnetic resonance image reconstruction device 1. In the following description, the k-space data $K_0$ is described as three-dimensional tensor data with width $W \times$ height $H \times$ number $C$ of channels (number of receiving coils), where the width direction of the k-space data $K_0$ is a frequency encoding direction and the height direction of the k-space data $K_0$ is a phase encoding direction. Usually, magnetic resonance scans skip some coordinates in the phase-encoding direction (height direction) during the magnetic resonance scans in order to perform undersampling in which certain phase encodings are omitted to reduce scan time. As a result, in the k-space data $K_0$, no data is present on some coordinates in the height direction (phase encoding direction), and zero-padding processing is performed on the data on some coordinates mentioned above. Since data near the center position of the k-space data has a large impact on the contrast of image data to be reconstructed, it is common to intensively sample data near the center position in the phase-encoding direction and skip data at some locations far from the center position when undersampling is performed.

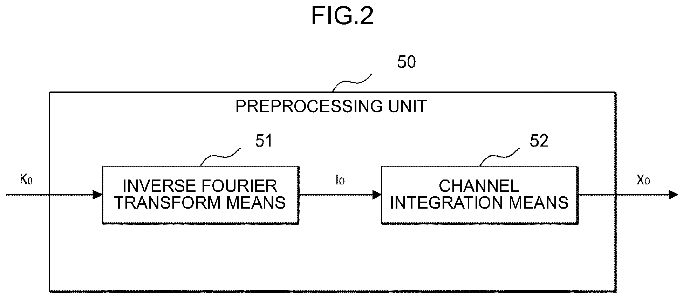

The process performed by the preprocessing unit 50 is described below. FIG. 2 is a data flow diagram for explaining the process performed by the preprocessing unit 50 according to the first embodiment. In FIG. 2, a data flow is indicated by solid arrows.

Referring to FIG. 2, the preprocessing unit 50 has inverse Fourier transform means 51 and channel integration means 52. The inverse Fourier transform means 51 performs an inverse Fourier transform on data by using an algorithm such as an inverse fast Fourier transform. The channel integration means 52 integrates multichannel data corresponding to each of the receiving coils of the magnetic resonance scanning device into data for one channel.

The preprocessing unit 50 generates initial image data $X_0$ by preprocessing the undersampled k-space data $X_0$.

First, the preprocessing unit 50 reads the k-space data $K_0$ from the storage unit 40 and performs an inverse Fourier transform on the k-space data $K_0$ by using the inverse Fourier transform means 51 to generate multichannel image data $I_0$. The multichannel image data $I_0$ is image space data whose width, height, and number of channels are the same as those of the k-space data $K_0$. The data of each channel of the multichannel image data $I_0$ is image space data transformed from the k-space data collected by each receiving coil.

Subsequently, the preprocessing unit 50 uses the channel integration means 52 to generate the initial image data $X_0$ by integrating the data of multiple channels of the multichannel image data $I_0$ into data for one channel on the basis of the sensitivity of each receiving coil. The initial image data $X_0$ is two-dimensional image data with width $W \times$ height $H$. Since the initial image data $X_0$ is directly generated by the undersampled k-space data $K_0$, artifacts and noise are present, causing problems such as lack of details and blurring of images.

Returning to the description of FIG. 1. The reconstruction unit 60 reconstructs the complete image data, which is the magnetic resonance image data equivalent to the fully sampled k-space data, for example, on the basis of the initial image data $X_0$. The embodiment is not limited thereto, and the magnetic resonance image data to be reconstructed may be image data with image quality equivalent to a reconstructed image based on fully sampled k-space data, or image data from which artifacts caused by undersampling are removed.

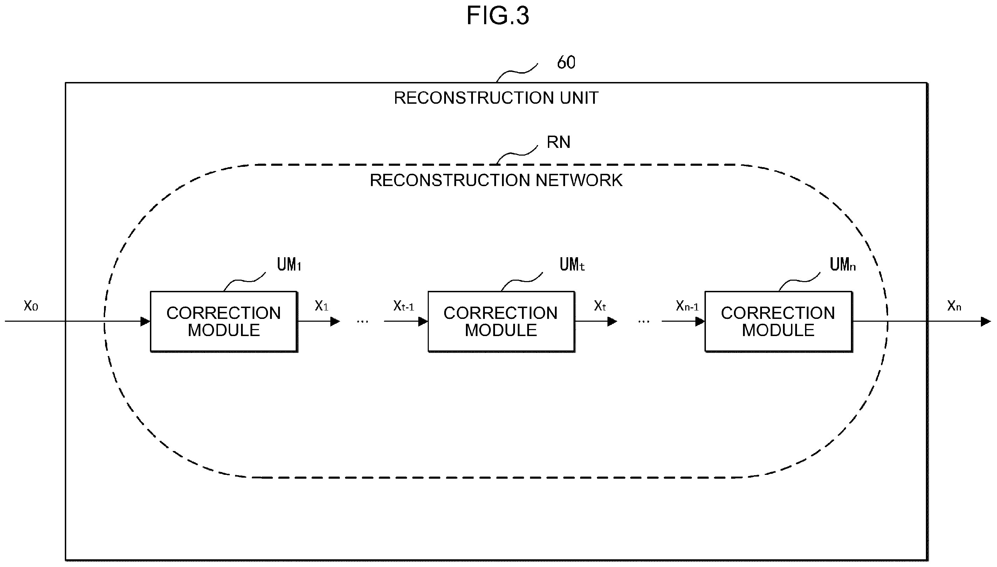

The reconstruction process performed by the reconstruction unit 60 is described below. FIG. 3 is a data flow diagram for explaining the reconstruction process performed by the reconstruction unit 60 according to the first embodiment. In FIG. 3, a data flow is indicated by solid arrows.

Referring to FIG. 3, the reconstruction unit 60 has a reconstruction network RN. The reconfiguration network RN includes n (n is an integer equal to or greater than 1) serially connected correction modules $UM_1$ to $UM_n$. The number n of reconfiguration networks RNs is preferably 8 to 10. Hereafter, when the correction modules $UM_1$ to $UM_n$ are not

distinguished from one another, they are collectively referred to as a correction module UM. The correction module UM performs a correction process on image data so that the image data approaches complete image data.

The reconstruction unit 60 reconstructs the complete image data equivalent to the fully sampled k-space data by correcting the initial image data $X_0$ by using the reconstruction network RN.

First, the reconstruction unit 60 inputs the initial image data $X_0$ and the k-space data $K_0$ acquired from the preprocessing unit 50 into the reconstruction network RN.

Subsequently, the reconstruction network RN inputs the initial image data $X_0$ and the k-space data $K_0$ to the correction module $UM_1$ located at the foremost stage, and the correction module $UM_1$ generates corrected image data $X_1$ by correcting the initial image data $X_0$ on the basis of the initial image data $X_0$, the k-space data $K_0$, and mask data (not illustrated), and outputs the corrected image data $X_1$ to the correction module $UM_2$. The corrected image data $X_1$ is an image closer to the complete image data than the initial image data $X_0$. The mask data indicates which phase encodings of the k-space data $K_0$ have been sampled and which phase encodings of the k-space data $K_0$ have been omitted in the magnetic resonance scan. The mask data is, for example, a matrix of width W × height H, where the width direction of the matrix is a frequency encoding direction and the height direction of the matrix is a phase encoding direction. The mask data is set to 1 for the value of an element of coordinates of frequency and phase encodings where sampling has been performed, and 0 for the value of an element of coordinates of the frequency and phase encodings where no sampling has been performed.

Subsequently, on the basis of corrected image data output from a correction module at a previous stage, the k-space data $K_0$, and the mask data, each of the correction modules $UM_2$ to $UM_{n-1}$ further corrects the corrected image data output from the correction module at the previous stage and outputs the further corrected image data to a next stage. The operation of the correction module UM is described using the correction module UMt (t is an integer equal to or greater than 2 and less than N) as an example. On the basis of corrected image data $X_{t-1}$ output from a correction module $UM_{t-1}$ at a previous stage, the k-space data $K_0$, and the mask data, the correction module UMt corrects the corrected image data $X_{t-1}$ to be closer to the complete image data, generates the further corrected image data $X_t$, and outputs the corrected image data $X_t$ having been corrected to the correction module $UM_{t+1}$.

Finally, the correction module $UM_n$ generates corrected image data $X_n$ on the basis of corrected image data $X_{n-1}$ output from a correction module $UM_{n-1}$ at a previous stage, the k-space data $K_0$, and the mask data, and outputs the corrected image data $X_n$ as an estimated value of the complete image data.

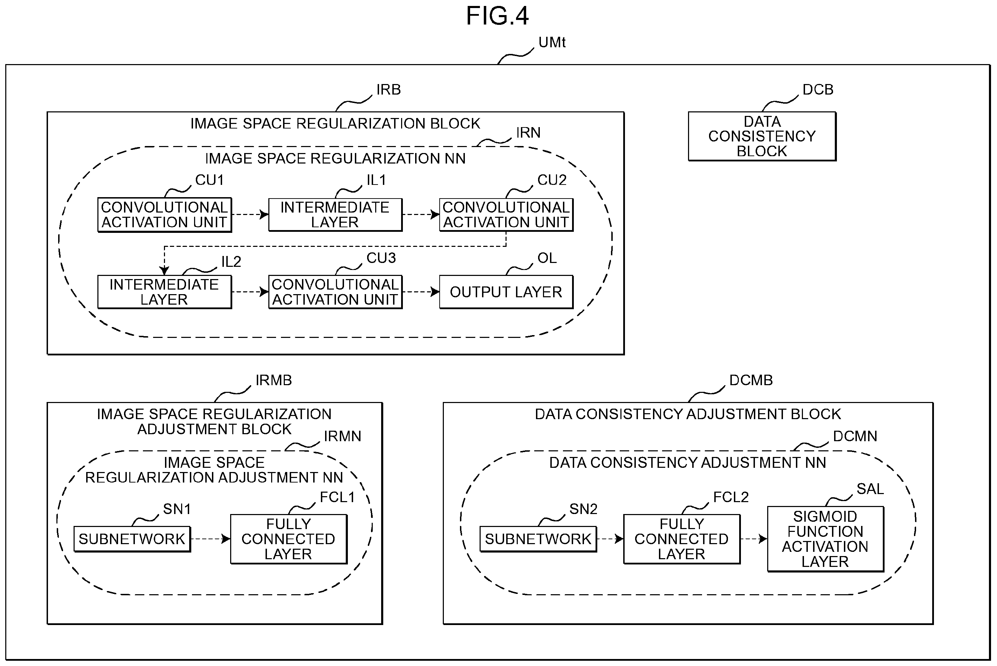

The configuration of the correction module UM is described below using the configuration of the correction module UMt as an example. Since the other configurations of the correction module UM are the same as the configurations of the correction module UMt, a redundant description thereof is omitted. FIG. 4 is a block diagram for explaining the configuration of the correction module UMt according to the first embodiment. In FIG. 4, the connection relationships between parts are indicated by dashed arrows

Referring to FIG. 4, the correction module UMt includes an image space regularization adjustment block IRMB, an image space regularization block IRB, a data consistency adjustment block DCMB, and a data consistency block DCB.

The image space regularization adjustment block IRMB adjusts a regularization process by the image space regularization block IRB. The image space regularization adjustment block IRMB uses an image space regularization adjustment neural network IRMN to generate multiple feature adjustment tensors and multiple activation adjustment tensors on the basis of the corrected image data $X_{t-1}$ input from the correction module $UM_{t-1}$ at a previous stage, and the number of feature adjustment tensors and the number of activation adjustment tensors are determined by the number of convolutional activation units of an image space regularization neural network IRN of the image space regularization block IRB to be described later. The feature adjustment tensor adjusts output results of a convolution layer in the convolutional activation unit of the image space regularization neural network IRN to be described later. The activation adjustment tensor adjusts the process of each activation layer in the convolutional activation unit of the image space regularization neural network IRN to be described later. Each parameter used by the image space regularization adjustment neural network IRMN is stored in the storage unit 40. The image space regularization adjustment neural networks IRMN included in different correction modules UM may have different parameters from each other, or may share parameters. The image space regularization adjustment neural networks IRMN included in the different correction modules UM preferably have different parameters from each other.

The image space regularization adjustment neural network IRMN includes a subnetwork SN1 and a fully connected layer FCL1. The subnetwork SN1 functions as an image feature extractor and is composed of a feedforward neural network, a convolutional neural network, a transformer, and the like. The subnetwork SN1 is preferably composed of a convolutional neural network. The fully connected layer FCL1 has multiple nodes connected to all output nodes of the subnetwork SN1, and integrates image features extracted by the subnetwork SN1.

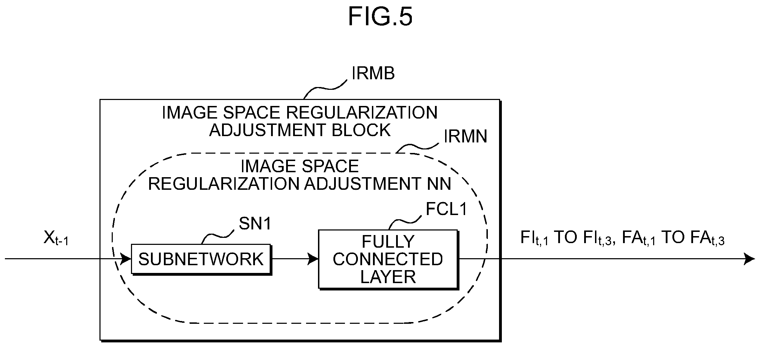

The process by the image space regularization adjustment block IRMB is described below. FIG. 5 is a data flow diagram for explaining the process by the image space regularization adjustment block IRMB included in the correction module UMt according to the first embodiment. In FIG. 5, a data flow is indicated by solid arrows.

Referring to FIG. 5, the image space regularization adjustment block IRMB inputs the corrected image data $X_{t-1}$

input from the correction module $UM_{t-1}$ at a previous stage to the image space regularization adjustment neural network IRMN, and the image space regularization adjustment neural network IRMN analyzes the corrected image data $X_{t-1}$ on the basis of a learned neural network and generates feature adjustment tensors $FI_{t,1}$ to $FI_{t,3}$ and activation adjustment tensors $FA_{t,1}$ to $FA_{t,3}$ for the corrected image data $X_{t-1}$.

Specifically, the image space regularization adjustment neural network IRMN inputs the corrected image data $X_{t-1}$ to the subnetwork SN1, extracts image features of the corrected image data $X_{t-1}$, delivers the image features to the fully connected layer FCL1, integrates the image features extracted by the subnetwork SN1 into the fully connected layer FCL1, and generates the feature adjustment tensors $FI_{t,1}$ to $FI_{t,3}$ and the activation adjustment tensors $EA_{t,1}$ to $FA_{t,3}$. Each of the sizes of the feature adjustment tensors $FI_{t,1}$ to $FI_{t,3}$ coincides with the size of each convolution layer in the convolutional activation unit of the image space regularization neural network IRN to be described below, and each of the sizes of the feature adjustment tensors $FI_{t,1}$ to $FI_{t,3}$ coincides with the size of each activation layer in the convolutional activation unit of the image space regularization neural network IRN to be described below.

Returning to the description of FIG. 4. The image space regularization block IRB performs an image space regularization process. The image space regularization block IRB uses the image space regularization neural network IRN to perform a regularization process in the image space on the corrected image data $X_{t-1}$ input from the correction module $UM_{t-1}$ at a previous stage. The image space regularization neural network IRN is a convolutional neural network including three convolutional activation units CU1 to CU3, intermediate layers IL1 and IL2, and an output layer OL, and the output layer OL of the image space regularization neural network IRN outputs two-dimensional image data of width W × height H. The intermediate layers IL1 and IL2 and the output layer OL are, for example, a pooling layer, a batch normalization layer, a fully connected layer, an activation layer, or a combination thereof. Details of the convolutional activation units CU1 to CU3 are described later. In the present embodiment, the number of convolutional activation units of the image space regularization neural network IRN is set to three for convenience of description; however, the number of convolutional activation units of the image space regularization neural network IRN is not limited thereto and may be any integer of 1 or more. For convenience of description, the configuration of the image space regularization neural network IRN has been simplified; however, the configuration of the image space regularization neural network IRN is not limited thereto. The image space regularization neural network IRN is preferably a U-net. Each parameter used by the image space regularization neural network IRN is stored in the storage unit 40. Image space regularization neural networks IRNs included in different correction modules UM may have parameters different from each other or share parameters. The image space regularization neural networks IRNs included in the different correction modules UM preferably have parameters different from each other.

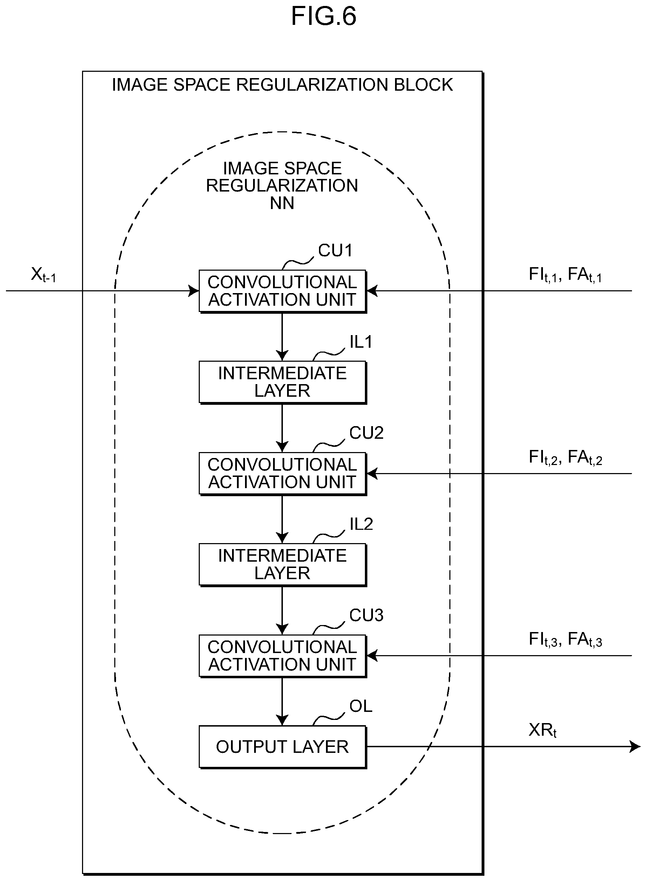

The process by the image space regularization block IRB is described below. FIG. 6 is a data flow diagram for explaining the process by the image space regularization block IRB included in the correction module UMt according to the first embodiment. In FIG. 6, a data flow is indicated by solid arrows.

Referring to FIG. 6, the image space regularization block IRB inputs, to the image space regularization neural network IRN, the corrected image data $X_{t-1}$ input from the correction module $UM_{t-1}$ at a previous stage, the feature adjustment tensors $FI_{t,1}$ to $FI_{t,3}$ input from the image space regularization adjustment neural network IRMN, and the activation adjustment tensors $EA_{t,1}$ to $FA_{t,3}$, and the image space regularization neural network IRN generates regularized image data XRt by performing regularization in the image space on the corrected image data $X_{t-1}$ on the basis of the learned neural network. The process of the image space regularization neural network IRN is considered to perform artifact removal and noise removal on image data of the corrected image data $X_{t-1}$ in the image space.

Specifically, the image space regularization neural network IRN first inputs the corrected image data $X_{t-1}$ to the convolutional activation unit CU1, and the convolutional activation unit CU1 uses the feature adjustment tensor $FI_{t,1}$ and the activation adjustment tensor $EA_{t,1}$ to perform, on the corrected image data $X_{t-1}$, a convolutional activation process adjusted on the basis of the image data of the corrected image data $X_{t-1}$, and then delivers extracted image feature data to the intermediate layer IL1. Details of the convolutional activation process are described later. The intermediate layer IL1 performs a necessary process on the received image feature data, and delivers the processed image feature data to the convolutional activation unit CU2. Since processes performed by the convolutional activation units CU2 and CU3 and the intermediate layer IL2 are similar to those of the convolutional activation unit CU1 and the intermediate layer IL1, a redundant description thereof is omitted. Finally, the output layer OL converts image feature data output by the convolutional activation unit CU3 into two-dimensional image data of width W × height H and outputs the two-dimensional image data as the regularized image data XRt.

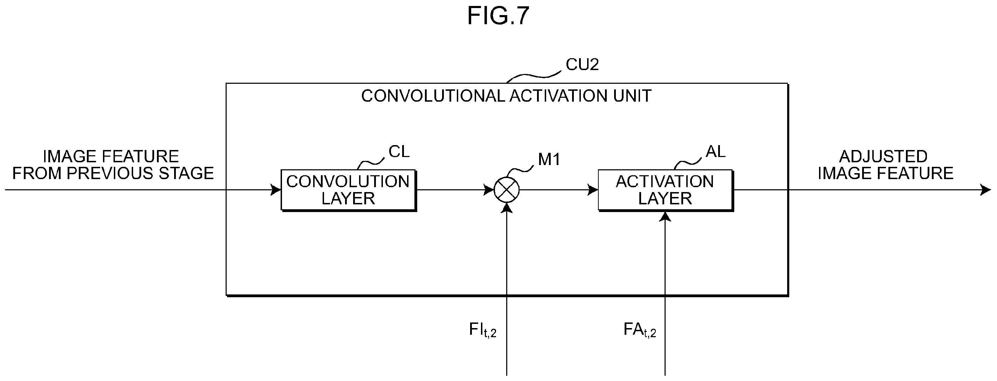

The convolutional activation processes performed by the convolutional activation units CU1 to CU3 are described below by using the convolutional activation unit CU2 as an example. Since the structures of the convolutional activation units CU1 and CU3 and the convolutional activation processes performed by the convolutional activation units CU1 and CU3 are similar to those of the convolutional activation unit CU2, a redundant description thereof is omitted. FIG. 7 is a data flow diagram for explaining the convolutional activation process performed by the convolutional activation unit CU2 included in the image space regularization neural network IRN according to the first embodiment. In FIG. 7, a data flow is indicated by solid arrows.

Referring to FIG. 7, the convolutional activation unit CU2 includes a convolution layer CL, a multiplier M1, and an activation layer AL. When the convolutional activation process is performed, the convolutional activation unit CU2 first delivers image features regarding the corrected image data $X_{t-1}$ received from a previous layer (intermediate layer IL1) to the convolution layer CL to perform the convolution process, and calculates higher-level image features. Subsequently, the convolutional activation unit CU2 uses the multiplier M1 to calculate a Hadamard product of the image features output from the convolution layer CL and the feature adjustment tensor $FI_{t,2}$, thereby adjusting the image features output from the convolution layer CL based on the corrected image data $X_{t-1}$. Subsequently, the activation layer AL activates the adjusted image features by using the activation adjustment tensor $FA_{t,2}$ and an activation function. The activation function is, for example, a rectified linear unit, a leaky rectified linear unit, a softshrink function, an exponential linear unit, or the like. The activation layer AL adjusts a threshold value of the activation function (for example, a softshrink function) on the basis of the activation adjustment tensor $FA_{t,2}$ or calculates a Hadamard product of image features activated by the activation function and the activation adjustment tensor $FA_{t,2}$, thereby activating the image features on the basis of the corrected image data $X_{t-1}$. Finally, the convolutional activation unit CU2 delivers the activated image features to a next layer (intermediate layer IL2).

By calculating the Hadamard product of the image features as well as the feature adjustment tensor and the activation adjustment tensor, element-level adjustments can be made to the image features on the basis of information of the corrected image data $X_{t-1}$. This allows the convolutional activation process to be adjusted according to the characteristics of images.

Returning to the description of FIG. 4. The data consistency adjustment block DCMB adjusts the data consistency process by the data consistency block DCB. The data consistency adjustment block DCMB uses the data consistency adjustment neural network DCMN to generate data consistency weights on the basis of the regularized image data XRt input from the image space regularization block IRB. The data consistency weights are scalar quantities for weighting and adjusting data consistency strength constants for the data consistency block DCB to be described later. Each parameter used by the data consistency adjustment neural network DCMN is stored in the storage unit 40. Data consistency adjustment neural networks DCMNs included in different correction modules UM may have different parameters, or share parameters. The data consistency adjustment neural networks DCMN included in the different correction modules UM preferably have parameters different from each other.

The data consistency adjustment neural network DCMN includes a subnetwork SN2, a fully connected layer FCL2, and a sigmoid function activation layer SAL. The subnetwork SN2 operates as an image feature extractor and is composed of a feedforward neural network, a convolutional neural network, a transformer, and the like. The subnetwork SN2 is preferably composed of a convolutional neural network. The fully connected layer FCL2 has multiple nodes connected to all output nodes of the subnetwork SN2, and integrates image features extracted by the subnetwork SN2. The sigmoid function activation layer SAL converts tensor data output by the fully connected layer FCL2 into a single scalar quantity.

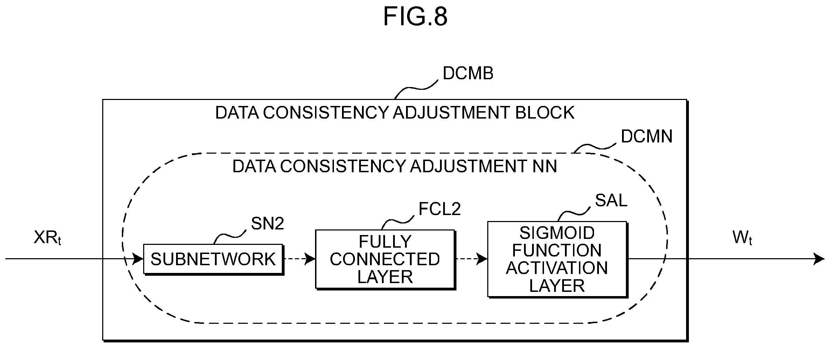

The process by the data consistency adjustment block DCMB is described below. FIG. 8 is a data flow diagram for explaining the process by the data consistency adjustment block DCMB included in the correction module UMt of the first embodiment. In FIG. 8, a data flow is indicated by solid arrows.

Referring to FIG. 8, the data consistency adjustment block DCMB inputs the regularized image data XRt input from the image space regularization block IRB to the data consistency adjustment neural network DCMN, and the data consistency adjustment neural network DCMN analyzes the regularized image data XRt on the basis of the learned neural network and generates a data consistency weight $W_t$ based on the regularized image data XRt.

Specifically, the data consistency adjustment neural network DCMN inputs the regularized image data XRt to the subnetwork SN2, extracts image features of the regularized image data $XR_t$, and delivers the image features to the fully connected layer FCL2. The fully connected layer FCL2 integrates the image features extracted by the subnetwork SN2 and delivers the result to the sigmoid function activation layer SAL. On the basis of the result, the sigmoid function activation layer SAL generates the data consistency weight $W_t$ to be used by the data consistency block DCB.

Returning to the description of FIG. 4. The data consistency block DCB performs the data consistency process. The data consistency block DCB performs the data consistency process so that the k-space data corresponding to the regularized image data XRt output by the image space regularization block IRB approaches the k-space data $K_0$, on the basis of the data consistency weight $W_t$, and generates the corrected image data $X_t$. The data consistency process aims to make the corrected image data $X_t$ as consistent as possible with the k-space data $K_0$ being original scan data.

Specifically, the data consistency block DCB calculates the corrected image data $X_t$ by using the following equation (1).

$$X_t = argmin\ \lambda\ ||A(X_t) - K_0||^2 + ||X_t - XR_t||^2 \qquad (1)$$

However, $\lambda$ is a data consistency strength and A is a forward operator. The forward operator A(Xt) represents first performing a Fourier transform on the corrected image data $X_t$ and then calculating a Hadamard product with the mask data in a k-space. The operation of the forward operator A transforms the corrected image data $X_t$ into the k-space data corresponding to the k-space data $K_0$, that is, the values for the coordinates of the frequency and phase encodings where sampling has been performed have normal values and the values for the coordinates of the frequency and phase encodings where no sampling has been performed are 0.

The data consistency strength $\lambda$ is calculated by the following equation (2).

$$\lambda = \lambda_0 \times W_t \qquad (2)$$

However, $\lambda_0$ is a data consistency strength constant, and the data consistency strength constant $\lambda_0$ may be a preset fixed value or a learnable value. By weighting and adjusting the data consistency strength constant $\lambda_0$ by using the data consistency weight $W_t$, the strength of the data consistency process can be adjusted on the basis of the information of the corrected image data $X_{t-1}$.

The data consistency block DCB can solve equation (1) above by an optimization algorithm such as a gradient descent method or a near-end mapping method. A conjugate gradient method is used for the near-end mapping method.

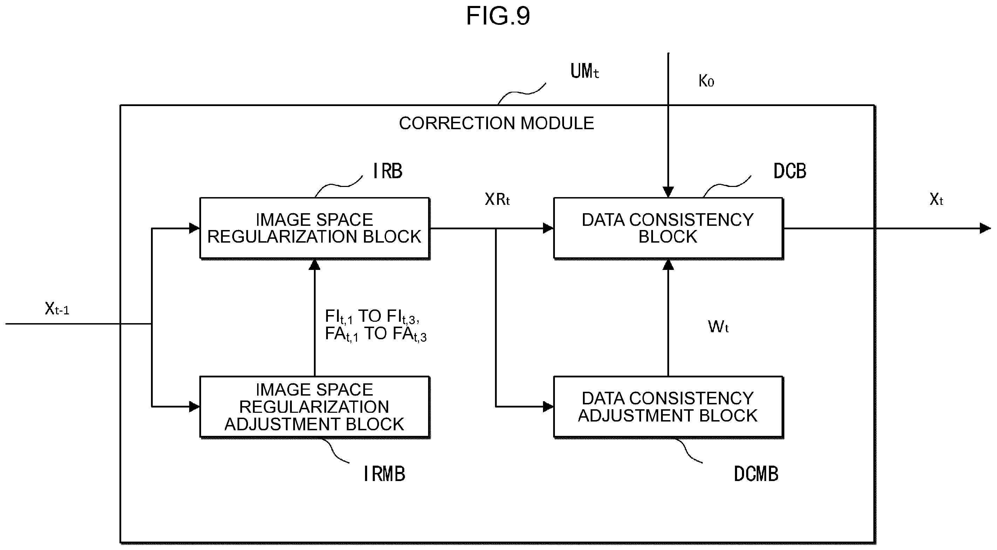

The process by the correction module UMt is described below. FIG. 9 is a data flow diagram for explaining the process by the correction module UMt according to the first embodiment. In FIG. 9, a data flow is indicated by solid arrows.

Referring to FIG. 9, the correction module UMt sequentially performs the following processes.

(1) The corrected image data $X_{t-1}$ is input to the image space regularization adjustment block IRMB and the image space regularization block IRB.

(2) The image space regularization adjustment block IRMB generates the feature adjustment tensors $FI_{t,1}$ to $FI_{t,3}$ and the activation adjustment tensors $EA_{t,1}$ to $FA_{t,3}$ on the basis of the corrected image data $X_{t-1}$ and outputs the generated tensors to the image space regularization block IRB.

(3) The image space regularization block IRB generates the regularized image data XRt on the basis of the corrected image data $X_{t-1}$, the feature adjustment tensors $FI_{t,1}$ to $FI_{t,3}$, and the activation adjustment tensors $EA_{t,1}$ to $FA_{t,3}$, and outputs the regularized image data XRt to the data consistency adjustment block DCMB and the data consistency block DCB.

(4) The data consistency adjustment block DCMB generates the data consistency weight $W_t$ on the basis of the regularized image data XRt and outputs the data consistency weight $W_t$ to the data consistency block DCB.

(5) The data consistency block DCB generates the corrected image data $X_t$ on the basis of the regularized image data XRt, the data consistency weight $W_t$, and the k-space data $K_0$.

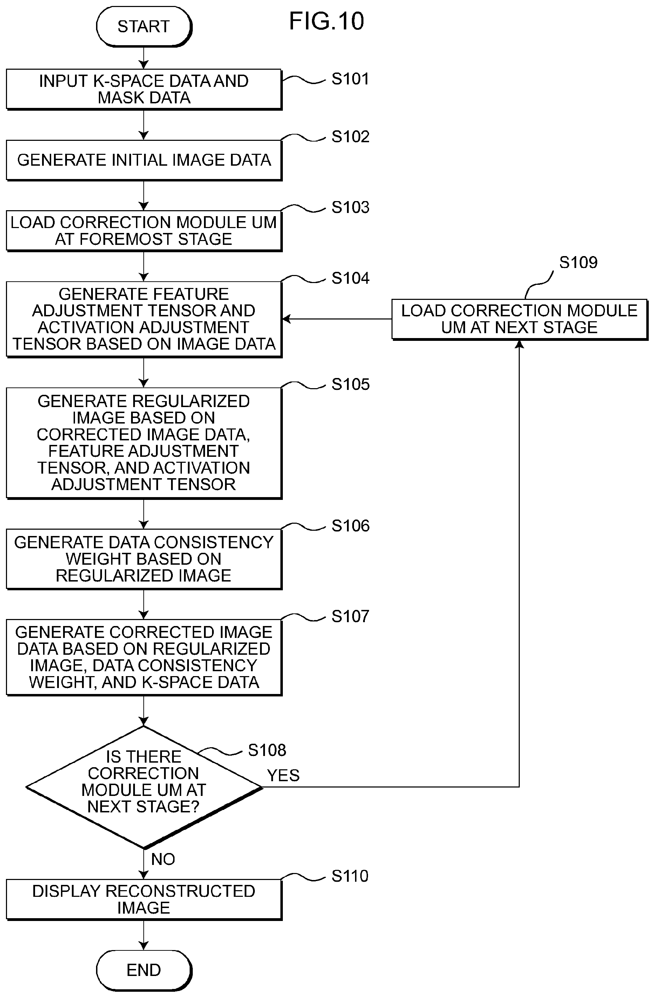

The flow of the magnetic resonance image reconstruction method according to the first embodiment is described below. FIG. 10 is a flowchart illustrating the flow of the magnetic resonance image reconstruction method according to the first embodiment.

At step S101, a user selects the undersampled k-space data $K_0$ and the mask data stored in the storage unit 40 or input from outside, by the input device on the basis of a user interface displayed on the display device, and inputs the selected data to the magnetic resonance image reconstruction device 1. After the process of step S101 is completed, the procedure proceeds to step S102.

At step S102, the preprocessing unit 50 generates the initial image data $X_0$ on the basis of the undersampled k-space data $K_0$. After the process of step S102 is completed, the procedure proceeds to step S103.

At step S103, the reconstruction unit 60 loads the correction module UM at the foremost stage of the reconstruction network RN from the storage unit 40, and inputs the undersampled k-space data $K_0$, the mask data, and the initial image data $X_0$ to the correction module UM at the foremost stage. After the process of step S103 is completed, the procedure proceeds to step S104.

At step S104, the correction module UM causes the image space regularization adjustment block IRMB to generate a feature adjustment tensor and an activation adjustment tensor on the basis of the input image data. After the process of step S104 is completed, the procedure proceeds to step S105.

At step S105, the correction module UM causes the image space regularization block IRB to generate a regularized image on the basis of the input image data, the feature adjustment tensor, and the activation adjustment tensor. After the process of step S105 is completed, the procedure proceeds to step S106.

At step S106, the correction module UM causes the data consistency adjustment block DCMB to generate the data consistency weight on the basis of the regularized image. After the process of step S106 is completed, the procedure proceeds to step S107.

At step S107, the correction module UM causes the data consistency block DCB to generate corrected image data on the basis of the regularized image, the data consistency weight, and the undersampled k-space data $K_0$. After the

process of step S107 is completed, the procedure proceeds to step S108.

At step S108, the presence or absence of the correction module UM at a next stage is determined. When the correction module UM at the next stage is present (determined to be YES), the procedure proceeds to step S109. When the correction module UM at the next stage is not present (determined to be NO), the procedure proceeds to step S110.

At step S109, the correction module UM at the next stage is loaded, and the undersampled k-space data $K_0$, the mask data, and the corrected image data are input to the correction module UM at the next stage. After the process of step S109 is completed, the procedure proceeds to step S104.

At step S110, the reconstructed image data is displayed on the display device via the display interface 20 as complete image data. When the process of step S110 is completed, the procedure of the magnetic resonance image reconstruction method is ended.

In the above description, the magnetic resonance image reconstruction device and the magnetic resonance image reconstruction method of the present embodiment are based on the image space regularization adjustment neural network IRMN, the image space regularization neural network IRN, the data consistency adjustment neural network DCMN, and the data consistency strength constant $\lambda_0$, and prior learning is required for these neural networks and parameters to operate normally. A learning method of the neural network and the parameter described above are described below.

First, multiple sets of pre-stored teacher data are read from the storage unit 40. Each set of teacher data includes, as input data, the undersampled k-space data $K_0$ obtained by a scan using the magnetic resonance scanning device and the mask data associated with the undersampled k-space data $K_0$, and includes the true value of the complete image data as output data. The teacher data preferably has image data with different characteristics.

Subsequently, the multiple sets of teacher data are divided into a training set and a test set. Examples of the percentage of the training set and the test set include 80%, 20%, 90%, 10%, or the like. For example, when the total number of teacher data is 10000 sets, the teacher data from data #1 to #10000 are divided into data #1 to #8000 as training sets and data #8001 to #10000 as test sets. In such a case, the input data in each set of teacher data in the training set is input to the magnetic resonance image reconstruction device 1, the magnetic resonance image reconstruction method of the present embodiment is performed to calculate an estimated value of complete image data, a difference value between the estimated value of the complete image data and the true value of the complete image data is calculated, and backpropagation is performed on the basis of the difference, so that parameters of each neural network and other learnable parameters are changed so that the difference value between the estimated value of the complete image data output by the magnetic resonance image reconstruction device 1 and the true value of the complete image data is reduced. The above process is repeated for the majority of data in the training set until the difference value between the estimated value of the complete image data output by the magnetic resonance image reconstruction device 1 and the true value of the complete image data is smaller than a preset threshold value. At this time, training of each neural network and parameter is determined to be completed.

Subsequently, the input data of the test data (data #8000 to #10000) is input to the learned magnetic resonance image reconstruction device 1, and the difference value between the estimated value of the complete image data output by the magnetic resonance image reconstruction device 1 and the true value of the complete image data is calculated as evaluation data.

The effects of the magnetic resonance image reconstruction device and the magnetic resonance image reconstruction method of the present embodiment are described below.

A magnetic resonance device in the related art under-samples k-space information in a frequency domain and generates undersampled k-space data in order to reduce a scanning time. Since reconstruction of complete image data using the undersampled k-space data is an ill-posed problem, countless solutions are present and exact complete image data is not able to be uniquely specified. Magnetic resonance image reconstruction devices and magnetic resonance image reconstruction methods based on deep learning techniques solve this problem by using a compressive sensing algorithm, and uniquely specify one suitable solution by adding a learned neural network as a sparsity constraint.

In magnetic resonance image reconstruction devices and magnetic resonance image reconstruction methods based on deep learning techniques in the related art, when complete image data is reconstructed using a learned neural network, since the parameters of a neural network and an algorithm that perform a correction process including a regularization process and an image consistency process are fixed values, the same process is performed regardless of the characteristics of an input image.

In the present invention, the complete image data is reconstructed using the correction modules $UM_1$ to $UM_n$, and each correction module UM further includes the image space regularization adjustment block IRMB and the data consistency adjustment block DCMB that adjust a regularization process and an image consistency process in addition to the image space regularization block IRB and the data consistency block DCB that perform the regularization process and the image consistency process.

The image space regularization adjustment block IRMB can generate a feature adjustment tensor and an activation adjustment tensor on the basis of image data being corrected, and dynamically adjust the operations of a convolution layer and an activation layer in the image space regularization neural network IRN of the image space regularization block IRB. The data consistency adjustment block DCMB can generate data consistency weights on the basis of image data being corrected and dynamically adjust the data consistency strength of the data consistency block DCB. Since the feature adjustment tensor, the activation adjustment tensor, and the data consistency weights are not fixed values, but values corresponding to information of the image data being corrected, a process can be performed according to the characteristics of the image data. According to the present invention, an optimal image reconstruction process can be performed according to the characteristics of input data, thereby improving the accuracy of image reconstruction.

Compared to the related art, the MSE between the estimated value of the complete image data generated by the magnetic resonance image reconstruction device 1 of the present embodiment and the true value of the complete image data is lower than that of the magnetic resonance image reconstruction method based on deep learning techniques in the related art, and the SSIM and PSNR are higher than those of the magnetic resonance image reconstruction method based on deep learning techniques in the related art.

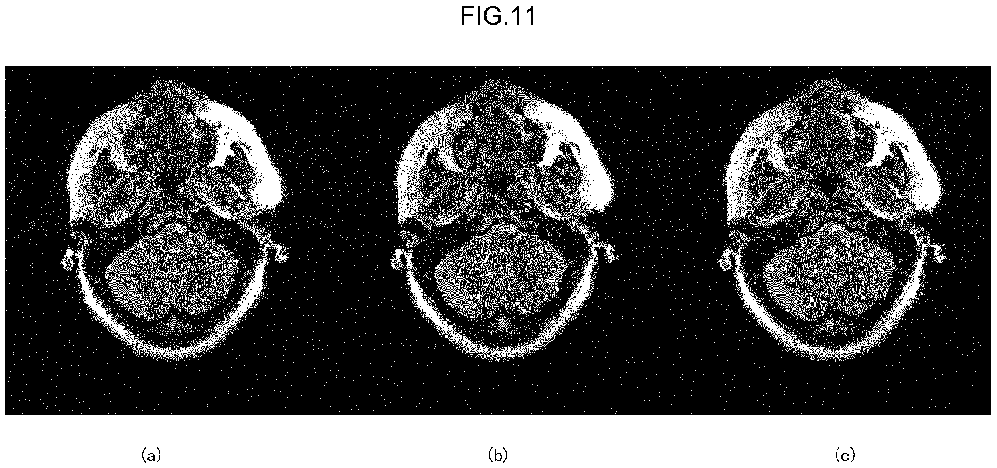

FIG. 11 is a diagram comparing complete image data reconstructed by the magnetic resonance image reconstruction device 1 of the first embodiment with complete image data reconstructed according to the related art.

FIG. 11(a) illustrates local real image data of the cerebellum, FIG. 11(b) illustrates local image data of the cerebellum reconstructed according to the related art when 5X undersampling is performed, and FIG. 11(c) illustrates local image data of the cerebellum reconstructed by the magnetic resonance image reconstruction device 1 of the present embodiment when the 5X undersampling is performed.

As can be seen from FIG. 11, when the 5X undersampling is performed, the image data reconstructed by the magnetic resonance image reconstruction device 1 of the present embodiment has a relatively high degree of reproducibility to the real image data, more details restored, sharper edges of the restored cerebellar tissue, and higher image clarity compared to the image data reconstructed according to the related art. The image data reconstructed by the magnetic resonance image reconstruction device 1 of the present embodiment well restores a sulcus structure in the cerebellum.

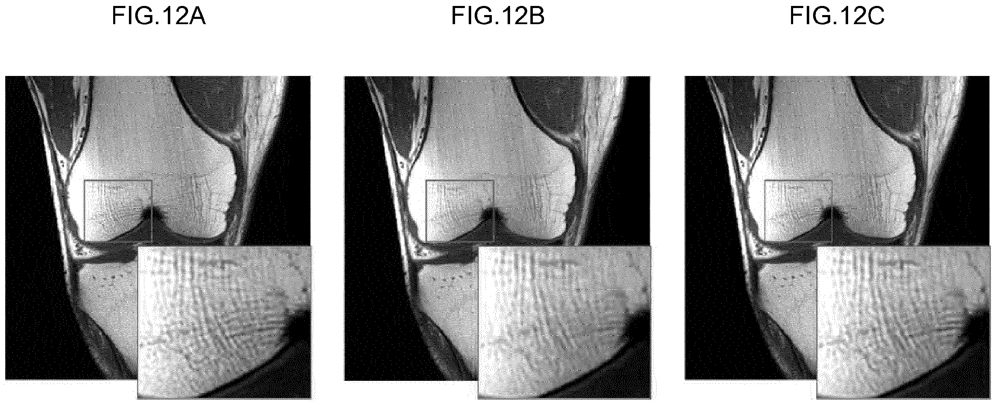

FIG. 12 is a diagram comparing complete image data reconstructed by the magnetic resonance image reconstruction device 1 of the first embodiment with complete image data reconstructed according to the related art.

FIG. 12(a) illustrates actual image data of the knee, FIG. 12(b) illustrates image data of the knee reconstructed according to the related art when 5X undersampling is performed, and FIG. 12(c) illustrates image data of the knee reconstructed by the magnetic resonance image reconstruction device 1 of the present embodiment when the 5X undersampling is performed.

As can be seen from FIG. 12, when the 5X undersampling is performed, the image data reconstructed by the magnetic resonance image reconstruction device 1 of the present embodiment has a relatively high degree of reproducibility to the real image data, more details restored, and higher image clarity compared to the image data reconstructed according to the related art. The image data reconstructed by the magnetic resonance image reconstruction device 1 of the present embodiment well restores a textural structure of the patella.

Second Embodiment

A magnetic resonance image reconstruction device and a magnetic resonance image reconstruction method of the second embodiment are described below. In the second embodiment, the differences from the first embodiment are mainly described, and points in common with the first embodiment are omitted. In the description of the second embodiment, the same reference numerals are used for the same parts as in the first embodiment.

In comparison to the first embodiment, a magnetic resonance image reconstruction device 1 of the second embodiment has $UMA_1$ to $UMA_n$ instead of the correction modules $UM_1$ to $UM_n$.

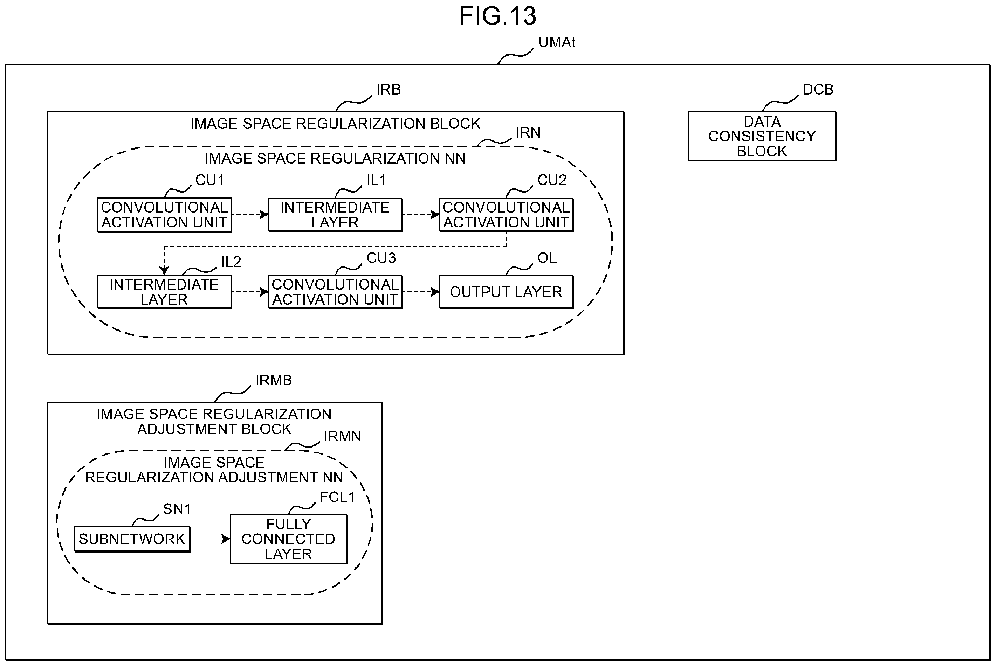

The configuration of the correction module UMA is described below using the configuration of the correction module $UMA_t$ as an example. Since the other configurations of the correction module UMA are the same as the configurations of the correction module $UMA_t$, a redundant description thereof is omitted. FIG. 13 is a block diagram for explaining the configuration of the correction module $UMA_t$ according to the second embodiment.

In comparison to the correction module UMt of the first embodiment, the correction module $UMA_t$ has no data consistency adjustment block DCMB, and the other configurations are the same as those of the correction module UMt of the first embodiment.

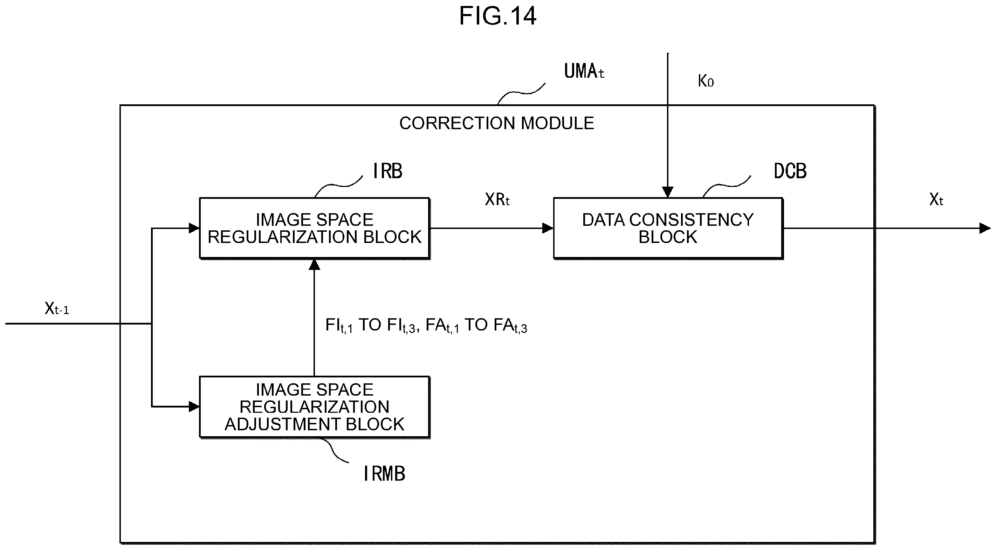

A process performed by the correction module $UMA_t$ is described below. FIG. 14 is a data flow diagram for explaining the process by the correction module $UMA_t$ according to the second embodiment.

Referring to FIG. 14, the correction module $UMA_t$ sequentially performs the following processes.

(1) The corrected image data $X_{t-1}$ is input to the image space regularization adjustment block IRMB and the image space regularization block IRB.
(2) The image space regularization adjustment block IRMB generates the feature adjustment tensors $FI_{t,1}$ to $FI_{t,3}$ and the activation adjustment tensors $EA_{t,1}$ to $FA_{t,3}$ on the basis of the corrected image data $X_{t-1}$ and outputs the generated tensors to the image space regularization block IRB.

(3) The image space regularization block IRB generates the regularized image data XRt on the basis of the corrected image data $X_{t-1}$, the feature adjustment tensors $FI_{t,1}$ to $FI_{t,3}$, and the activation adjustment tensors $EA_{t,1}$ to $FA_{t,3}$, and outputs the regularized image data XRt to the data consistency block DCB.

(4) The data consistency block DCB generates the corrected image data $X_t$ on the basis of the regularized image data XRt and the k-space data $K_0$.

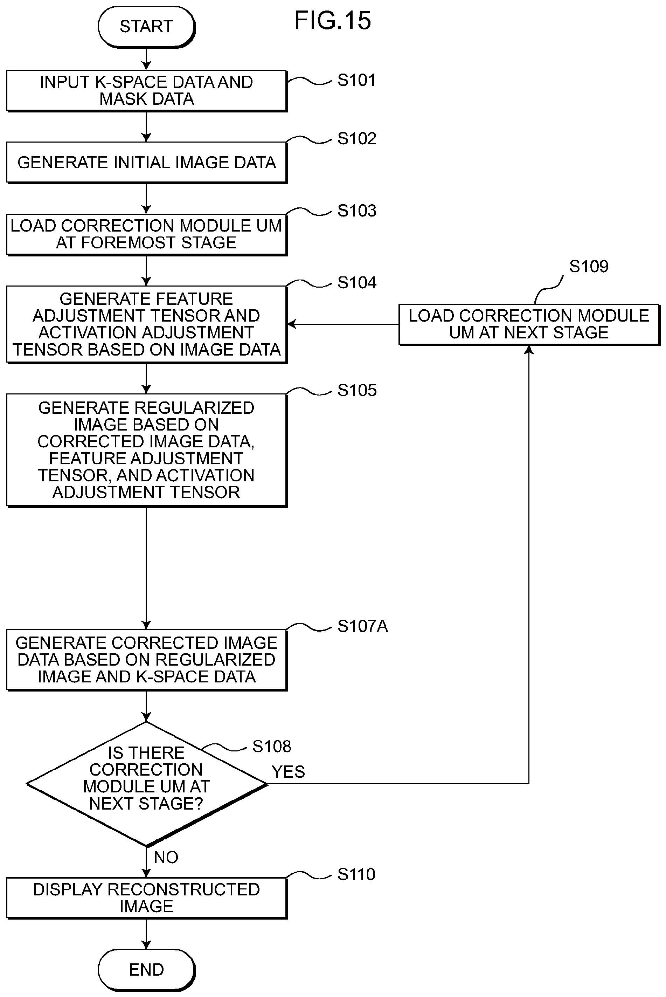

FIG. 15 is a flowchart illustrating the flow of the magnetic resonance image reconstruction method according to the second embodiment. Compared to the first embodiment, the magnetic resonance image reconstruction method according to the second embodiment has no step S106 and has step S107A instead of step S107.

At step S107, the correction module UM causes the data consistency block DCB to generate corrected image data on the basis of the regularized image and the undersampled k-space data $K_0$.

Third Embodiment

A magnetic resonance image reconstruction device and a magnetic resonance image reconstruction method of the third embodiment are described below. In the third embodiment, the differences from the first embodiment are mainly described, and points in common with the first embodiment are omitted. In the description of the third embodiment, the same reference numerals are used for the same parts as in the first embodiment.

In comparison to the first embodiment, a magnetic resonance image reconstruction device 1 of the third embodiment has $UMB_1$ to $UMB_n$ instead of the correction modules $UM_1$ to $UM_n$.

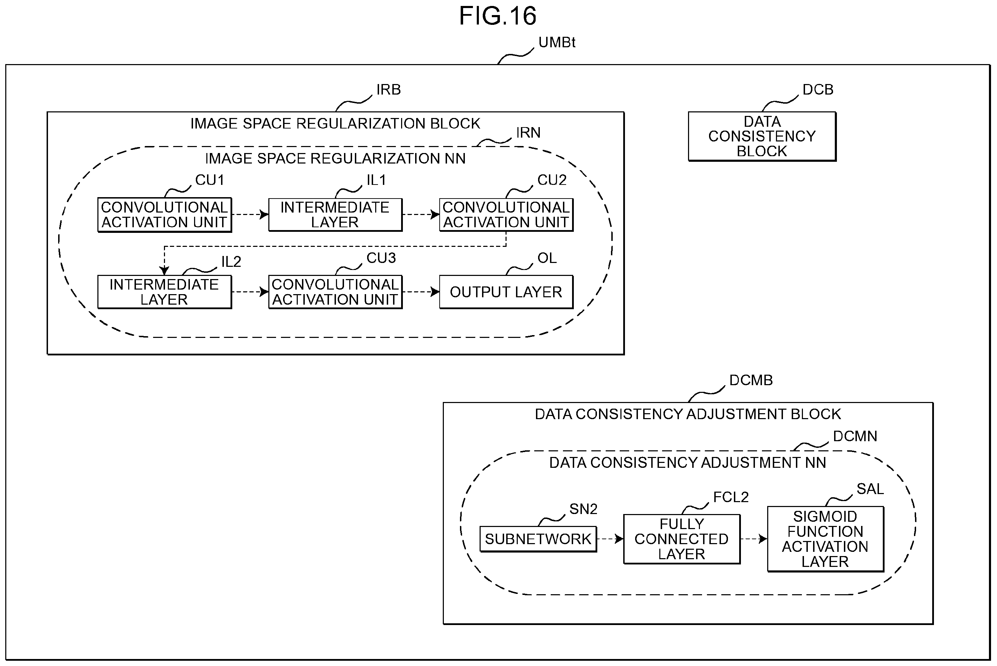

The configuration of the correction module UMB is described below using the configuration of the correction module $UMB_t$ as an example. Since the other configurations of the correction module UMB are the same as the configurations of the correction module $UMB_t$, a redundant description thereof is omitted. FIG. 16 is a block diagram for explaining the configuration of the correction module $UMA_t$ according to the third embodiment.

The correction module $UMB_t$ has no image space regularization adjustment block IRMB compared to the correction module UMt of the first embodiment, and the other configurations are the same as those of the correction module UMt of the first embodiment.

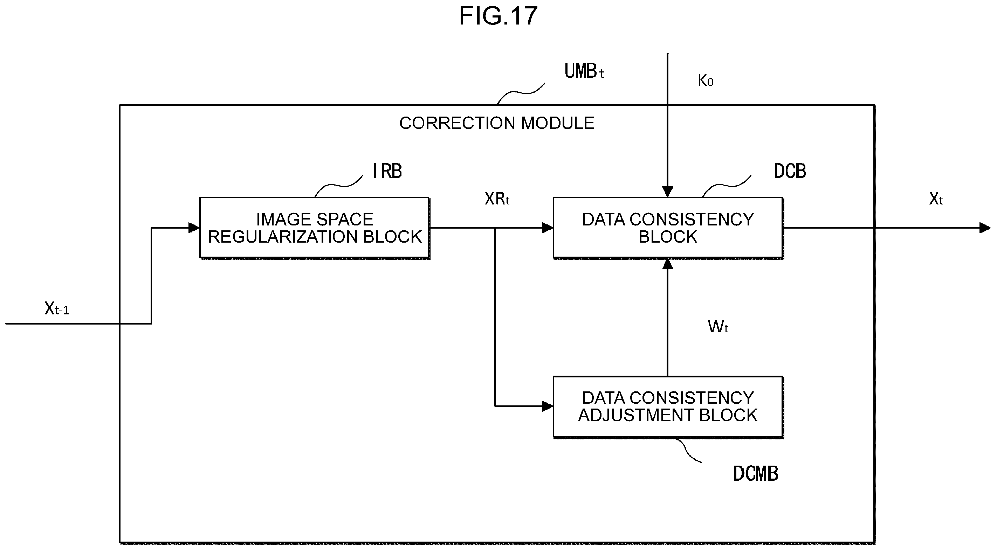

A process performed by the correction module $UMB_t$ is described below. FIG. 17 is a data flow diagram for explaining the process by the correction module $UMB_t$ according to the third embodiment.

Referring to FIG. 17, the correction module UMBt sequentially performs the following processes.

(1) The corrected image data $X_{t-1}$ is input to the image space regularization block IRB.

(2) The image space regularization block IRB generates the regularized image data XRt on the basis of the corrected image data $X_{t-1}$ and outputs the regularized image data XRt to the data consistency adjustment block DCMB and the data consistency block DCB.

(3) The data consistency adjustment block DCMB generates the data consistency weight $W_t$ on the basis of the regularized image data XRt and outputs the data consistency weight $W_t$ to the data consistency block DCB.

(4) The data consistency block DCB generates the corrected image data $X_t$ on the basis of the regularized image data XRt, the data consistency weight $W_t$, and the k-space data $K_0$.

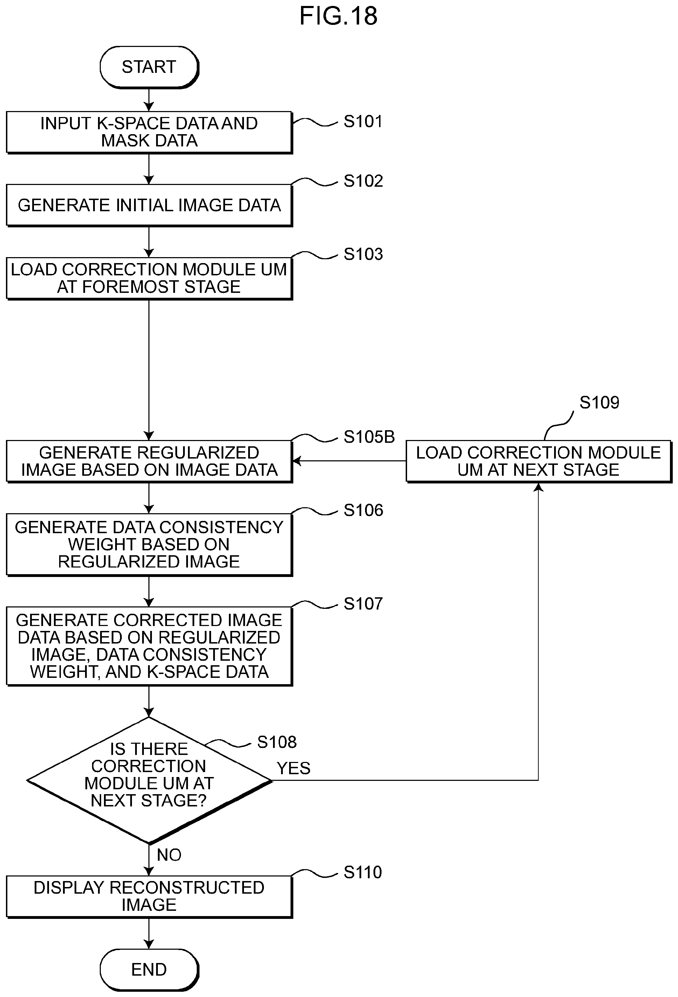

FIG. 18 is a flowchart illustrating the flow of the magnetic resonance image reconstruction method according to the third embodiment. Compared to the first embodiment, the magnetic resonance image reconstruction method according to the third embodiment has no step S104 and has step S105B instead of step S105.

At step S105B, the correction module UM causes the image space regularization block IRB to generate a regularized image on the basis of the input image data. After the process of step S109 is completed, the procedure proceeds to step S105B.

Modification

The above embodiment has described a case in which the reconstruction network RN corrects image data in an image space and reconstructs complete image data. However, the reconstruction network RN may correct k-space data in a **k**-space and reconstruct the complete image data. In this case, each correction module UM included in the reconstruction network RN corrects the k-space data $K_0$ to reconstruct the complete image data. The correction module UM may include a k-space regularization adjustment block with a k-space regularization adjustment neural network and a k-space regularization block with a k-space regularization neural network, instead of the image space regularization adjustment block IRMB and the image space regularization block IRB.

The above embodiment has described a case in which the image space regularization adjustment block IRMB generates a feature adjustment tensor and an activation adjustment tensor. However, the image space regularization adjustment block IRMB may generate only the feature adjustment tensor or generate only the activation adjustment tensor. In this case, the image space regularization block IRB performs an image space regularization process on the basis of only one of the feature adjustment tensor and the activation adjustment tensor.

In the above embodiment, an example of outputting the modified image data Xt as an estimate value of the complete image data has been shown. However, after completing at least one iterative process, the regularized image data XRt may be output as an estimate value of the complete image data. In other words, in the plurality of iteration processes, processing by the data integrity block DCB may not be performed at the time of the last iteration process.

According to at least one of the embodiments described above, the image quality of reconstructed images can be improved.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the invention as defined by the appended claims. The accompanying claims are intended to cover such forms or modifications as would fall within the scope of the inventions.

**Claims**

1. A magnetic resonance image reconstruction device (1) that reconstructs magnetic resonance image data in which an artifact due to undersampling is removed or reduced, based on undersampled k-space data, the magnetic resonance image reconstruction device (1) comprising

   a reconstruction unit (60) configured to reconstruct the magnetic resonance image data by using a reconstruction network (RN) including a correction module (UMt), wherein
   the correction module (UMt) includes:

   a regularization block (IRN) configured to generate second image data by performing a regularization process on first image data by using a first neural network; and
   a data consistency block (DCB) configured to generate third image data by performing a data consistency process so that k-space data corresponding to the second image data approaches the undersampled k-space data, and

   the correction module (UMt) further includes at least one of a data consistency adjustment block (DCMB) configured to adjust the data consistency process and a regularization adjustment block (IRMB) configured to adjust the regularization process.

2. The magnetic resonance image reconstruction device (1) according to claim 1, wherein the regularization block (IRN) is configured to perform the regularization process in an image space by using the first neural network so that an artifact due to undersampling is removed or reduced.

3. The magnetic resonance image reconstruction device (1) according to claim 1, wherein

   the data consistency adjustment block (DCMB) is configured to generate a data consistency weight by using a second neural network based on the second image data, and
   the data consistency block (DCB) is configured to perform the data consistency process based on the data consistency weight.

4. The magnetic resonance image reconstruction device (1) according to claim 1, wherein

   the regularization adjustment block (IRMB) is configured to generate a first tensor by using a third neural network based on the first image data, and
   the regularization block (IRN) is configured to adjust a calculation in a convolution layer in the first neural network based on the first tensor.

5. The magnetic resonance image reconstruction device (1) according to claim 1, wherein

the regularization adjustment block (IRMB) is configured to generate a second tensor by using a fourth neural network based on the first image data, and

the regularization block (IRN) is configured to adjust a calculation in an activation layer in the first neural network based on the second tensor.

6. The magnetic resonance image reconstruction device (1) according to claim 4, wherein the regularization adjustment block (IRMB) includes a first image feature extractor configured to extract an image feature in the first image data and generate the first tensor based on the image feature.

7. The magnetic resonance image reconstruction device (1) according to claim 5, wherein the regularization adjustment block (IRMB) includes a first image feature extractor configured to extract an image feature in the first image data and generate the second tensor based on the image feature.

8. The magnetic resonance image reconstruction device (1) according to claim 3, wherein the data consistency adjustment block (DCMB) includes a second image feature extractor configured to extract an image feature in the second image data and generate the data consistency weight based on the image feature.

9. The magnetic resonance image reconstruction device (1) according to claim 4 or 5, wherein the third neural network is a convolutional neural network.

10. The magnetic resonance image reconstruction device (1) according to any one of claims 1 to 8, wherein

the reconstruction network (RN) includes a plurality of the correction modules (UMt), and
the first neural network of each of the correction modules (UMt) has different parameters.

11. The magnetic resonance image reconstruction device (1) according to claim 5 or 7, wherein an activation function of the activation layer is a ReLU function.

12. The magnetic resonance image reconstruction device (1) according to claim 1, wherein the regularization block (IRN) performs the regularization process in a k-space to generate the second image by using the first neural network so that k-space data corresponding to the first image data approaches fully sampled k-space data.

13. A magnetic resonance image reconstruction method for reconstructing magnetic resonance image data in which an artifact due to undersampling is removed or reduced, based on undersampled k-space data, the magnetic resonance image reconstruction method comprising:

performing regularization to generate second image data by performing a regularization process on first image data by using a first neural network;
performing data consistency to generate third image data by performing a data consistency process so that k-space data corresponding to the second image data approaches the undersampled k-space data; and
performing adjustment to adjust at least one of the regularization process and the data consistency process.

# FIG.1

1

MAGNETIC RESONANCE IMAGE
RECONSTRUCTION DEVICE

| | |
|---|---|
| INPUT/OUTPUT INTERFACE | 10 |
| DISPLAY INTERFACE | 20 |
| COMMUNICATION INTERFACE | 30 |
| STORAGE UNIT | 40 |
| PREPROCESSING UNIT | 50 |
| RECONSTRUC-TION UNIT | 60 |

# FIG.2

# FIG.3

RECONSTRUCTION UNIT — 60

RN

RECONSTRUCTION NETWORK

$UM_1$

$X_0$ → CORRECTION MODULE → $X_1$ ... $X_{t-1}$ →

$UM_t$

CORRECTION MODULE → $X_t$ ... $X_{n-1}$ →

$UM_n$

CORRECTION MODULE → $X_n$

# FIG.4

UMt

IRB

IMAGE SPACE REGULARIZATION BLOCK

IRN

IMAGE SPACE REGULARIZATION NN

CU1
CONVOLUTIONAL ACTIVATION UNIT

IL1
INTERMEDIATE LAYER

CU2
CONVOLUTIONAL ACTIVATION UNIT

IL2
INTERMEDIATE LAYER

CU3
CONVOLUTIONAL ACTIVATION UNIT

OL
OUTPUT LAYER

DCB
DATA CONSISTENCY BLOCK

IRMB

IMAGE SPACE REGULARIZATION ADJUSTMENT BLOCK

IRMN
IMAGE SPACE REGULARIZATION ADJUSTMENT NN

SN1
SUBNETWORK

FCL1
FULLY CONNECTED LAYER

DCMB

DATA CONSISTENCY ADJUSTMENT BLOCK

DCMN
DATA CONSISTENCY ADJUSTMENT NN

SN2
SUBNETWORK

FCL2
FULLY CONNECTED LAYER

SAL
SIGMOID FUNCTION ACTIVATION LAYER

EP 4 632 419 A2

FIG.5

EP 4 632 419 A2

# FIG.6

IMAGE SPACE REGULARIZATION BLOCK

IMAGE SPACE
REGULARIZATION
NN

$X_{t-1}$

CU1
CONVOLUTIONAL
ACTIVATION UNIT

$FI_{t,1}, FA_{t,1}$

IL1
INTERMEDIATE
LAYER

CU2
CONVOLUTIONAL
ACTIVATION UNIT

$FI_{t,2}, FA_{t,2}$

IL2
INTERMEDIATE
LAYER

CU3
CONVOLUTIONAL
ACTIVATION UNIT

$FI_{t,3}, FA_{t,3}$

OL
OUTPUT LAYER

$XR_t$

# FIG.7

CU2

CONVOLUTIONAL ACTIVATION UNIT

IMAGE FEATURE
FROM PREVIOUS STAGE

CL

CONVOLUTION
LAYER

M1

AL

ACTIVATION
LAYER

ADJUSTED
IMAGE FEATURE

$FI_{t,2}$

$FA_{t,2}$

EP 4 632 419 A2

# FIG.8

# FIG.9

# FIG.10

START

INPUT K-SPACE DATA AND MASK DATA — S101

GENERATE INITIAL IMAGE DATA — S102

LOAD CORRECTION MODULE UM AT FOREMOST STAGE — S103

GENERATE FEATURE ADJUSTMENT TENSOR AND ACTIVATION ADJUSTMENT TENSOR BASED ON IMAGE DATA — S104

GENERATE REGULARIZED IMAGE BASED ON CORRECTED IMAGE DATA, FEATURE ADJUSTMENT TENSOR, AND ACTIVATION ADJUSTMENT TENSOR — S105

GENERATE DATA CONSISTENCY WEIGHT BASED ON REGULARIZED IMAGE — S106

GENERATE CORRECTED IMAGE DATA BASED ON REGULARIZED IMAGE, DATA CONSISTENCY WEIGHT, AND K-SPACE DATA — S107

IS THERE CORRECTION MODULE UM AT NEXT STAGE? — S108

YES

S109

LOAD CORRECTION MODULE UM AT NEXT STAGE

NO

DISPLAY RECONSTRUCTED IMAGE — S110

END

FIG.11

FIG.12A

FIG.12B

FIG.12C

EP 4 632 419 A2

## FIG.13

UMAt

IRB

**IMAGE SPACE REGULARIZATION BLOCK**

IRN

IMAGE SPACE REGULARIZATION NN

CU1 → CONVOLUTIONAL ACTIVATION UNIT
IL1 → INTERMEDIATE LAYER
CU2 → CONVOLUTIONAL ACTIVATION UNIT

IL2 → INTERMEDIATE LAYER
CU3 → CONVOLUTIONAL ACTIVATION UNIT
OL → OUTPUT LAYER

DCB

DATA CONSISTENCY BLOCK

IRMB

**IMAGE SPACE REGULARIZATION ADJUSTMENT BLOCK**

IRMN

IMAGE SPACE REGULARIZATION ADJUSTMENT NN

SN1 → SUBNETWORK
FCL1 → FULLY CONNECTED LAYER

EP 4 632 419 A2

FIG.14

# FIG.15

START

INPUT K-SPACE DATA AND MASK DATA — S101

GENERATE INITIAL IMAGE DATA — S102

LOAD CORRECTION MODULE UM AT FOREMOST STAGE — S103

GENERATE FEATURE ADJUSTMENT TENSOR AND ACTIVATION ADJUSTMENT TENSOR BASED ON IMAGE DATA — S104

GENERATE REGULARIZED IMAGE BASED ON CORRECTED IMAGE DATA, FEATURE ADJUSTMENT TENSOR, AND ACTIVATION ADJUSTMENT TENSOR — S105

GENERATE CORRECTED IMAGE DATA BASED ON REGULARIZED IMAGE AND K-SPACE DATA — S107A

IS THERE CORRECTION MODULE UM AT NEXT STAGE? — S108

YES

S109

LOAD CORRECTION MODULE UM AT NEXT STAGE

NO

DISPLAY RECONSTRUCTED IMAGE — S110

END

## FIG.16

EP 4 632 419 A2

# FIG.17

UMB$_t$

K$_0$

CORRECTION MODULE

IRB

IMAGE SPACE
REGULARIZATION BLOCK

XR$_t$

DCB

DATA CONSISTENCY
BLOCK

X$_t$

X$_{t-1}$

W$_t$

DATA CONSISTENCY
ADJUSTMENT BLOCK

DCMB

EP 4 632 419 A2

# FIG.18

START

INPUT K-SPACE DATA AND MASK DATA — S101

GENERATE INITIAL IMAGE DATA — S102

LOAD CORRECTION MODULE UM AT FOREMOST STAGE — S103

GENERATE REGULARIZED IMAGE BASED ON IMAGE DATA — S105B

LOAD CORRECTION MODULE UM AT NEXT STAGE — S109

GENERATE DATA CONSISTENCY WEIGHT BASED ON REGULARIZED IMAGE — S106

GENERATE CORRECTED IMAGE DATA BASED ON REGULARIZED IMAGE, DATA CONSISTENCY WEIGHT, AND K-SPACE DATA — S107

IS THERE CORRECTION MODULE UM AT NEXT STAGE? — S108
YES

NO

DISPLAY RECONSTRUCTED IMAGE — S110

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180349759 A

**Non-patent literature cited in the description**

- **AGGARWAL HK** ; **MANI MP** ; **JACOB M**. MoDL: Model Based Deep Learning Architecture for Inverse Problems. *IEEE Trans Med Imaging*, 2019, vol. 38 (2), 394-405